# EUROPEAN PATENT APPLICATION

(11) **EP 3 783 680 A1**
(43) Date of publication of application: **24.02.2021**
(21) Application number: 19192886.0
(22) Date of filing: 21.08.2019
(51) Int. Cl.: H01L 51/42, H01L 27/30

(54) **RADIATION DETECTOR**

(71) Applicant: Freie Universität Berlin, 14195 Berlin (DE)
(72) Inventor: DALGLEISH, Louisa, 12169 Berlin (DE); DALGLEISH, Simon, 12169 Berlin (DE); SINGH, Arpana, 14195 Berlin (DE)
(74) Representative: Fischer, Uwe

(57) **Abstract**

An embodiment of the invention relates to a radiation detector (10) having a conversion unit (100) comprising a radiation-responsive conversion element (120) and an insulator forming a capacitor (C) in series with the conversion element (120). The embodiment is characterized in that the radiation detector (10) comprises two or more conversion units (100), wherein each of the conversion units (100) comprises a radiation-responsive conversion element (120) and an insulator forming a capacitor (C) in series with the conversion element (120), and wherein the insulators of said two or more conversion elements (120) are formed by a common electrolytic layer (130) that electrically couples the capacitors (C) and therefore the conversion units (100).

## Description

The invention relates to radiation detectors comprising conversion units and capacitors in series therewith.

### Background of the invention

The U.S patent application US 2018/248143 A1 describes a radiation detector comprising the features of the preamble of claim 1. The radiation detector has a conversion unit comprising a radiation-responsive conversion element and an insulator forming a capacitor in series with the conversion element.

### Objective of the present invention

An objective of the present invention is to provide improved radiation detectors.

### Brief summary of the invention

An embodiment of the present invention relates to a radiation detector having a conversion unit comprising a radiation-responsive conversion element and an insulator forming a capacitor in series with the conversion element. The radiation detector is characterized in that the radiation detector comprises two or more conversion units, wherein each of the conversion units comprises a radiation-responsive conversion element and an insulator forming a capacitor in series with the conversion element, and wherein the insulators of said two or more conversion elements are formed by a common electrolytic layer that electrically couples the capacitors and therefore the conversion units.

The coupling of the conversion units by said common electrolytic layer may cause crosstalk which may improve edge and motion detection.

The electrolytic layer preferably consists of or comprises material that forms or is at least able to form electric double layers.

Each of the coupled conversion units preferably comprises a first electrode and a second electrode.

The conversion element of each conversion unit is preferably located between the first electrode of the respective conversion unit and the electrolytic layer.

The electrolytic layer is preferably located between the conversion elements and the second electrodes.

Each of the coupled conversion units may comprise a second insulator that is located between the first electrode and the respective conversion element. The second insulator allows forming MISIM-devices as described in the above mentioned U.S patent application US 2018/248143 A1.

The plane of the electric double layers is preferably parallel to the plane in which the conversion elements are located.

The plane, in which the conversion elements are located, and the plane, in which the second electrodes are located, are preferably parallel. In this case, the plane of the electric double layers is preferably parallel to both of the latter planes.

Alternatively, the plane, in which the conversion elements are located, and the plane, in which the second electrodes are located, may be angled relative to each other, for instance arranged perpendicular to one another. In the latter case, the electric double layers of the electrolytic layer that are in contact with or adjacent to the second electrodes, are preferably parallel to the interface plane between the electrolytic layer and the second electrodes. The electric double layers of the electrolytic layer that are in contact with or adjacent to the conversion elements, are preferably parallel to the interface plane between the electrolytic layer and the conversion elements.

The radiation detector may comprise at least four coupled conversion units that form a one- or two-dimensional detector array of coupled conversion units.

In order to facilitate the fabrication, the conversion elements may be formed by a shared semiconductor layer.

According to a preferred embodiment, the radiation detector comprises a pre-processing unit configured to generate at least one pre-processed signal by combining the detector signals of at least two of the coupled conversion units.

The pre-processing unit is preferably electrically arranged between a post-processing unit (e.g. image processing unit) and the coupled conversion units.

The pre-processing unit is preferably configured to either transfer the detector signals of the at least two coupled conversion units and/or the respective pre-processed signal to the post-processing unit or block the transfer depending on a characteristic of the pre-processed signal.

The pre-processing unit may comprise at least one differential unit (e.g. differential amplifier) that generates the pre-processed signal by forming a differential signal based on the detector signals of at least two of the coupled conversion units.

The pre-processing unit may further comprise at least one transfer unit (e.g. switch) that transfers the detector signals of the at least two coupled conversion units and/or the respective differential signal to the post-processing unit if the amplitude of the differential signal exceeds a given threshold, and otherwise blocks the transfer.

In order to save energy, the post-processing unit is preferably configured to operate in a power saving mode at least with respect to those pairs of coupled conversion elements where the transfer of the detector signals and/or the transfer of the pre-processed signal is blocked.

The second electrodes of the coupled conversion units are preferably electrically connected or formed by a common electrode layer.

According to a further preferred embodiment, the radiation detector comprises two or more conversion sub-stacks that are stacked in a first direction.

Each of the conversion sub-stacks preferably comprises two or more conversion units that are electrically coupled to one another (at least coupled to neighbouring conversion units) and arranged in a plane perpendicular to the first direction.

In each conversion sub-stack, the conversion elements are preferably responsive to radiation that is inside a layer-individually assigned wavelength range, and unresponsive to radiation that is outside the layer-individually assigned wavelength range.

The conversion elements are preferably aligned in the first direction such that the conversion units form conversion pillars along the first direction.

Further, the conversion sub-stacks or at least a sub-group of sub-stacks may be connected by one or more through holes that allow a flow of the shared electrolytic layer between - along the first direction - successive sub-stacks. In the latter case, the conversion elements may be coupled in the plane of their respective sub-stacks, i.e. perpendicular to the first direction, as well as along the first direction.

### Brief description of the drawings

In order that the manner, in which the above-recited and other advantages of the invention are obtained, will be readily understood, a more particular description of the invention briefly described above will be rendered by reference to specific embodiments thereof which are illustrated in the appended drawings. Understanding that these drawings depict only typical embodiments of the invention and are therefore not to be considered to be limiting of its scope, the invention will be described and explained with additional specificity and detail by the use of the accompanying drawings in which
- Fig. 1-5: illustrate exemplary embodiments of the present invention where conversion elements are arranged in a single plane; and
- Fig. 6-7: illustrate exemplary embodiments of the present invention where conversion elements are arranged in multiple planes.

### Detailed description of the preferred embodiments

The preferred embodiments of the present invention will be best understood by reference to the drawings. It will be readily understood that the present invention, as generally described and illustrated in the figures herein, could vary in a wide range. Thus, the following more detailed description of the exemplary embodiments of the present invention, as represented in the figures, is not intended to limit the scope of the invention, as claimed, but is merely representative of presently preferred embodiments of the invention.

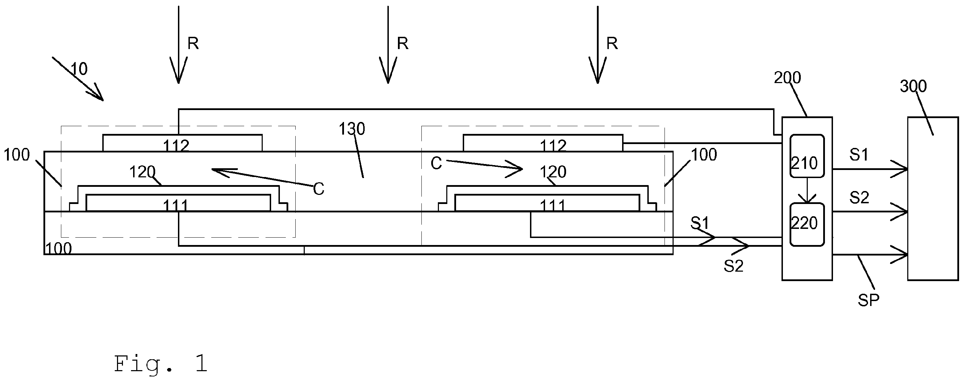

Figure 1 shows a first exemplary embodiment of a radiation detector 10 according to the present invention. The radiation detector 10 comprises two or more conversion units 100. Each of the conversion units 100 comprises a first electrode 111 located on top of a carrier 110, a radiation-responsive conversion element 120, an insulator forming a capacitor C in series with the respective conversion element 120, and a second electrode 112. The insulators of the conversion elements 120 are formed by a common electrolytic layer 130 that electrically couples the capacitors C and therefore the conversion units 100.

The electrolytic layer 130 preferably consists of material that forms or is at least able to form electric double layers. In the exemplary embodiment of Figure 1, the plane of the electric double layers is preferably parallel to the plane, in which the conversion elements 120 are located, as well as parallel to the plane, in which the second electrodes 112 are located.

In the exemplary embodiment of Figure 1, the second electrodes 112 are transparent and allow radiation R to pass the second electrodes 112 and reach the conversion elements 120.

The radiation detector 10 further comprises a pre-processing unit 200 and a post-processing unit 300.

The radiation detector 10 may be configured to operate as follows:
In case of illumination, the conversion units 100 generate detector signals S1 and S2 that are pre-processed by the pre-processing unit 200. The pre-processing unit 200 generates a pre-processed signal SP by combining the detector signals S1 and S2.

For instance, the pre-processing unit 200 may comprise a differential unit 210 (e.g. differential amplifier) that generates the pre-processed signal SP by forming a differential signal based on the detector signals S1 and S2.

The pre-processing unit 200 may further comprise a transfer unit 220 that transfers the detector signals S1 and S2 and/or the respective differential signal to the post-processing unit 300 only if the differential signal shows a predefined characteristic. The pre-processing unit 200 preferably transfers the signals only if the amplitude of the differential signal exceeds a given threshold. Otherwise the transfer unit 220 blocks the transfer to the post-processing unit 300.

The post-processing unit 300 may be an image processor that processes incoming detector signals S1 and S2 and/or the respective pre-processed signal SP (e.g. differential signal) in order to generate images and/or other evaluation results.

The post-processing unit 300 is preferably configured to operate in a power saving mode when the transfer of signals S1, S2 and SP is blocked and no signals for further processing are received.

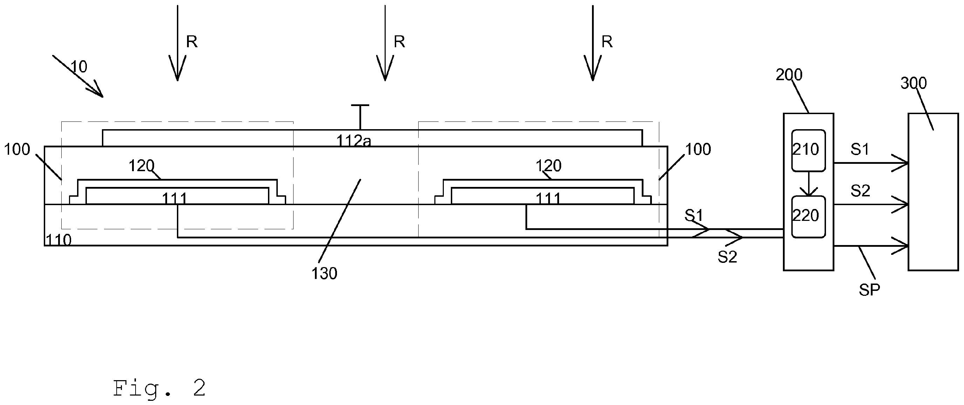

Figure 2 shows a second exemplary embodiment of a radiation detector 10 according to the present invention. In the exemplary embodiment of Figure 2, the second electrodes 112 of the conversion element 120 are formed by a single transparent layer, hereinafter referred to as second electrode layer 112a, which may be electrically grounded. Regarding the other features, the embodiment of Figure 2 may be identical to the embodiment of Figure 1.

In the exemplary embodiment of Figures 1 and 2, the plane, in which the conversion elements 120 are located, and the plane, in which the second electrodes 112 or the second electrode layer 112a are located, are parallel. Alternatively, these planes may be angled relative to each other, for instance arranged perpendicular to one another.

In the latter case, the electric double layers of the electrolytic layer 130 that are in contact with or adjacent to the second electrodes 112 or the second electrode layer 112a, are preferably parallel to the interface plane between the electrolytic layer 130 and the second electrodes 112 or the second electrode layer 112a. The electric double layers of the electrolytic layer 130 that are in contact with or adjacent to the conversion elements 120, are preferably parallel to the interface plane between the electrolytic layer 130 and the conversion elements 120. In other words, the electric double layers at both interfaces may be angled relatively to one another.

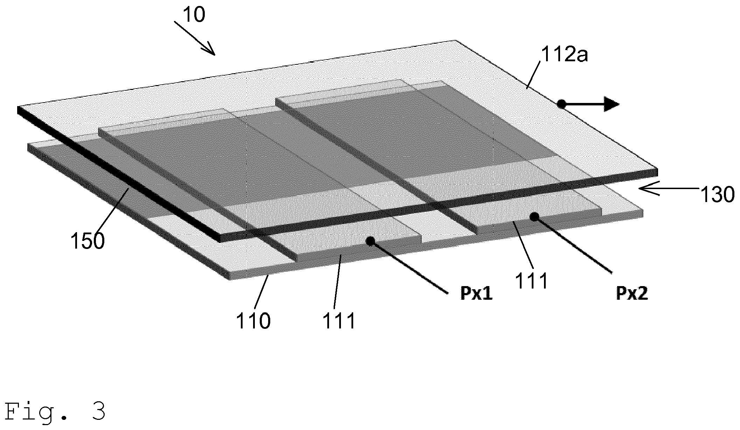

Figure 3 shows a 3-dimensional sketch of a third embodiment that is similar to the second embodiment of Figure 2.

The first electrodes 111 are formed by Au metal, onto which a photoactive semiconducting layer 150 (e. g. P3HT (Poly(3-hexylthiophene-2,5-diyl))-material and/or PCBM (Phenyl-C61-butyric acid methyl ester)-material was spin-coated. The photoactive semiconducting layer 150 forms the conversion elements 120 of Figure 2.

Another ITO substrate was used as counterelectrode and forms a common second electrode layer 112a that is glued to the bottom carrier 110 through the use of two adhesive polymer spacers (not shown) of about 60 µm thickness. The resulting void between the photoactive semiconducting layer 150 (P3HT/PCBM layer) and the counterelectrode 112a was filled with an ionic liquid 130 (e. g. EMIM (1-Ethyl-3-methylimidazolium), BF4, EB).

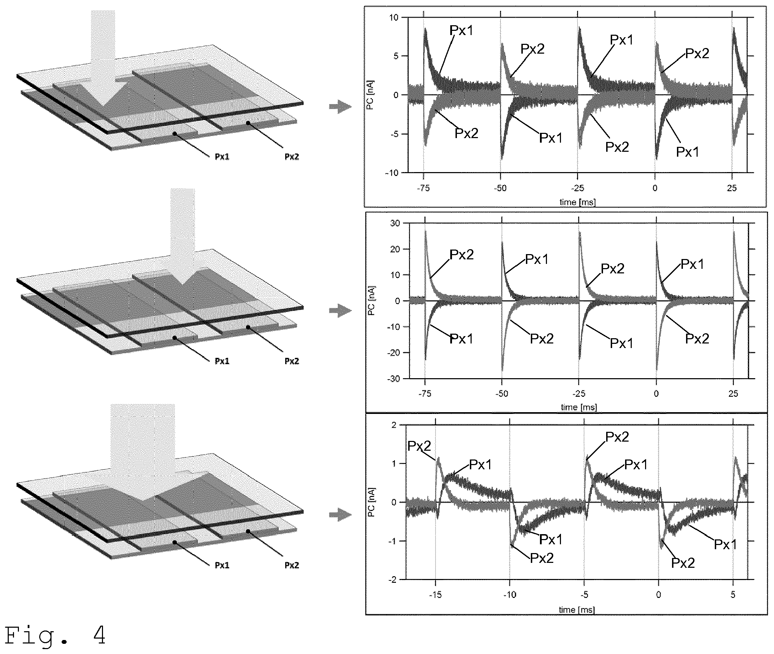

The semiconductor layer 150 and the allocated electrodes 111 form image pixels which are marked in Figure 3 and 4 by reference signs Px1 and Px2.

Figures 4 shows the behaviour of the embodiment of Figure 3 during illumination: More specifically, Figure 4 shows the photocurrent response of pixel Px1 and pixel Px2 depending on illumination position only on pixel Px1 (top), pixel Px2 (middle) and both pixels (bottom). The light was modulated at a frequency of 20 Hz (top and middle) and 100 Hz (bottom). For the bottom signal (both pixels illuminated) the signal amplification had to be increased from 10⁶ to 10⁷.

As can be seen in Figure 4, the photocurrent response measured by the individual pixels depends on the relative illumination compared to the illumination of the second pixel. If pixel Px1 is illuminated and pixel Px2 in the dark, a positive transient signal is obtained by pixel Px1, while a negative transient signal (of slightly reduced magnitude) is obtained by pixel Px2, thus the difference in signal intensity is of almost double the intensity obtained by pixel Px1 alone.

The same is the case (but with opposite polarities), when pixel Px2 is illuminated and pixel Px1 is covered. If both pixels are illuminated to the same degree, almost no signal is obtained from both pixels. This can be explained by the cumulative response of both pixels. The light falling on pixel Px1 induces a positive signal in pixel Px1, while the light falling onto pixel Px2 induces a negative signal in pixel Px1 (of almost the same intensity), thus the combined signal is strongly reduced in intensity.

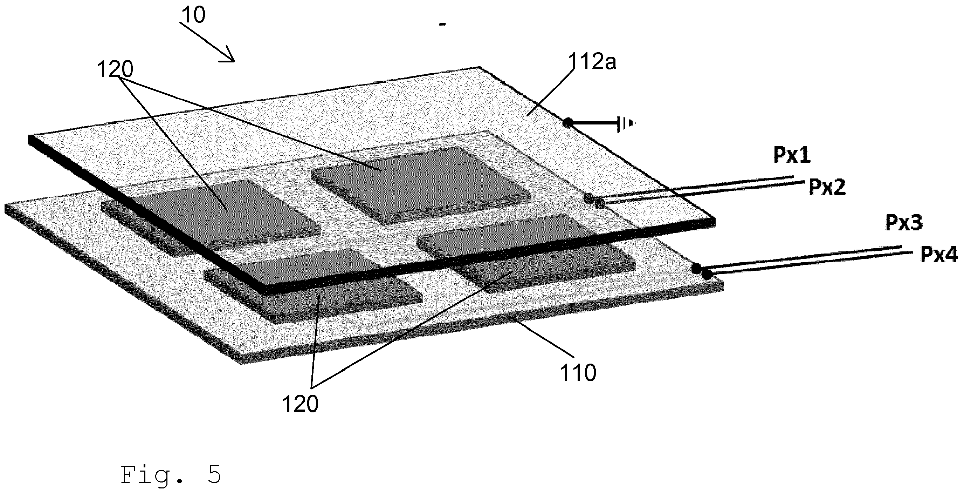

Figure 5 shows a fourth exemplary embodiment of a radiation detector 10 according to the present invention. The exemplary embodiment of Figure 4 comprises four conversion elements 120 arranged in the same plane. The second electrodes are formed by a single electrode layer 112a. Regarding the other features, the embodiment of Figure 5 may be identical to the embodiment of Figures 1-3.

In the embodiments of Figures 1,2 and 5, the conversion elements 120 are formed by separate elements, for instance separate semiconductor elements. The conversion elements 120 may consist of the same material or different materials. In the latter case, they may be responsive to different wavelength ranges (i.e. infrared, visible, etc).

Alternatively, as shown in Figures 3-4, the conversion elements 120 may be formed by a shared semiconductor layer 150. The shared semiconductor layer may be unstructured. A shared and/or unstructured semiconductor layer simplifies the fabrication process.

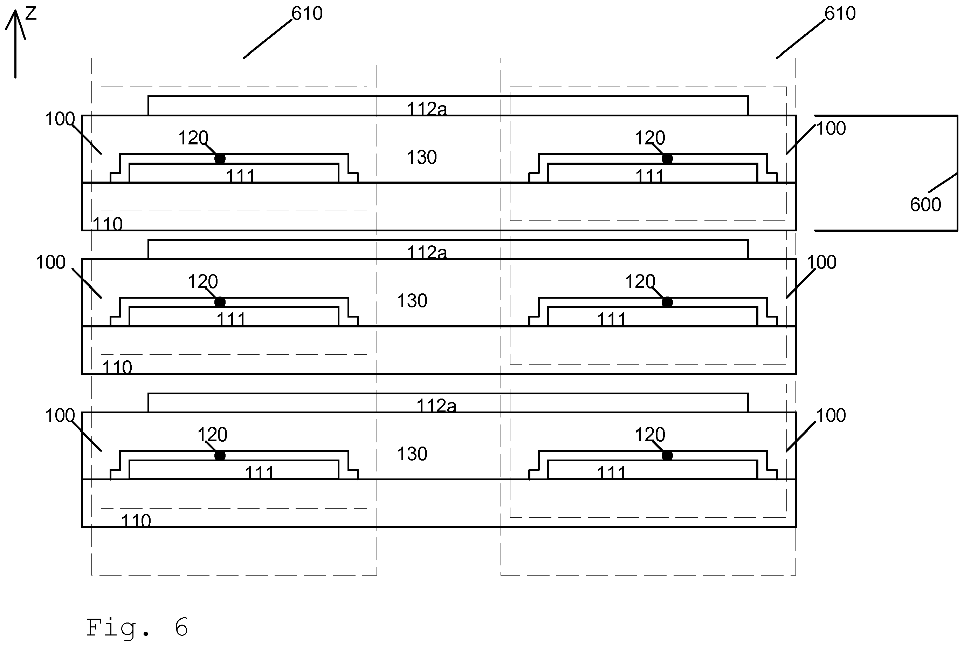

Figure 6 shows a fourth exemplary embodiment of a radiation detector 10 according to the present invention. In the exemplary embodiment of Figure 6, the radiation detector 10 comprises two or more conversion sub-stacks 600 that are stacked in a first direction Z. Each of the conversion sub-stacks 600 comprises two or more conversion units 100 that are electrically coupled to one another and arranged in a plane perpendicular to the first direction Z. In each conversion sub-stack 600, the conversion elements 120 are responsive to radiation that is inside a layer-individually assigned wavelength range, and unresponsive to radiation that is outside the layer-individually assigned wavelength range. For instance, the top conversion sub-stack 600 in Figure 6 may be responsive to visible blue radiation, the middle conversion sub-stack 600 responsive to visible red radiation and the bottom sub-stack 600 responsive to invisible infrared radiation. Of course, the above allocation of wavelength ranges is exemplary, only. Further, the conversion sub-stacks 600 may be designed for other wavelength ranges (e.g. other visible light (other colours), UV light (UV), NIR light as well as IR (thermal) wavelengths).

The conversion elements 120 are preferably aligned in the first direction Z such that the conversion units 100 form conversion pillars 610 along the first direction Z. The carriers 110 and the electrodes 111 and 112a are preferably transparent for all of the relevant wavelength ranges that the radiation detector 100 is supposed to detect. This allows radiation to pass upper sub-stacks and reach lower sub-stacks 600.

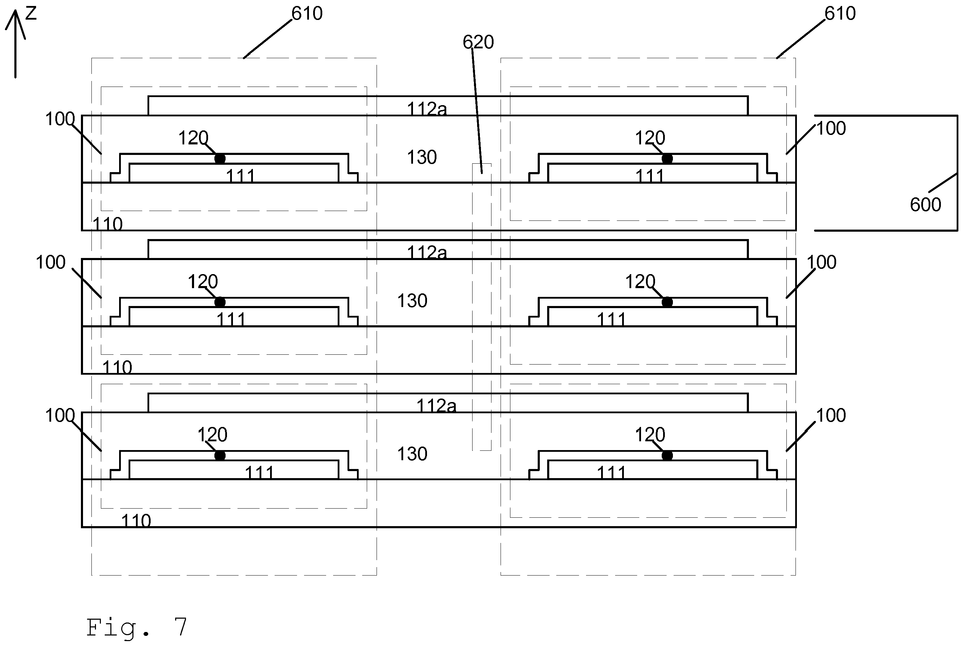

Figure 7 shows a fifth exemplary embodiment of a radiation detector 10 according to the present invention. In the exemplary embodiment of Figure 7, the conversion sub-stacks 600 or at least a sub-group of sub-stacks 600 are connected by one or more through holes 620 that allow a flow of shared electrolytic layer 130 between - along the first direction Z - successive sub-stacks 600. The flow of the shared electrolytic layer 130 couples the conversion elements 120 also in the first direction Z.

The exemplary embodiments described above as well as other exemplary embodiments of the present invention may be based on the share of components of individual photodetector units using MIS(I)M architecture, resulting in a structurally cross-linked photodetector array unit. This may be achieved through the use of (i) a common counter (second) electrode, and (ii) a common electrolytic insulating layer. The active (first) electrode may be patterned, and the semiconducting layer can be fabricated to cover this entire substrate. The pixel definition may result from the strongly localized signal transfer between the solid semiconducting layer just above the pixels patterned (first) electrode.

This cross-linked photodetector array unit may keep all the features associated with MIS(I)M photodetectors, such as insensitivity to background light (or slowly changing light), amplified responsivity due to the presence of the highly energetic SI interface etc.

The implemented crosslinking preferably leads to an intrinsic crosstalk between the individual pixels. This means that without the need of additional analogue or digital circuitry components, the pixels may obtain information about the electronic state of light activation present in its neighbouring pixels, which concomitantly may affect its own electronic response.

By adding this intrinsic crosstalk feature to photodetector array units, the image transferred to the "reader" has changed before being transferred to the digital memory and processing units, or in other words, the image has been pre-processed. This pre-processing may be based on 2 features: (i) edge detection i.e. through amplifying the signal if there is a clear edge (no light vs light) between neighbouring pixels, while decreasing the electronic signal transmitted by evenly illuminated neighbouring pixels, and thereby enhancing the contours in an image and (ii) motion detection, i.e. through keeping the differential nature of the MIS(I)M detector design inducing signals even in the absence of an additional shutter system by reacting to changes in light intensity. These changes in light intensity preferably falls within the bandwidth of the device, thus electronic reaction to e.g. slowly moving objects (like clouds) can be avoided. Both, the degree of sharpness in edge detection, as well as bandwidth in movement sensing are preferably tuneable through changes in structural and material parameters of the individual layers.

This kind of effect of pre-processing an image before further transferring the information may actually be similar to a principle operational feature of a natural eye of a living organism. Also here through common chemical pathways, the individual photoactive cells adjust their response to light depending on the illumination of the surrounding photocells. This provides the eyes (depending on the state of development) with a certain degree of image pre-processing (usually adjusted to the needs of the given organism), before the image is transferred to the brain, where the image can be further analysed. This pre-processing of the image is crucial for the survival of the living organisms, because the information processing is fast in the pre-processing state, and only the for the animal required information captured by its eye is transferred to the brain, which greatly reduces energy consumption and complexity of vision processing in the brain.

The MIS(I)M architecture may be designed for implementing organic materials as well as biomolecules [Dalgleish et al, Chem. Commun., 2015, 51, 16401-16404], and thus carries all the benefits associated with these kinds of materials (such as low cost, flexibility, tuneable wavelength range, biodegradability). Among these, the tuneable wavelength range characteristic for organic/bio materials, allows the implementation of a stacked architecture of the individual photodetector array units, in which each unit could be designed to respond to a specific wavelength range, without the use of additional filters (see for instance Fig. 7). This may not only reduce the cost through the avoidance of additional filters, but also the space (i.e. in the embodiments depicted in Figures 1-7, 1 pixel of the radiation detector (e.g. photodetector array unit), corresponds to 1 pixel in the resulting image). It should be noted, that the additional dimensionality of obtained information per pixel is not limited to the visible light, but a layer corresponding to e.g. IR light (i.e. heat) can be implemented in an analogous way.

It can be argued that such effects are already feasible in ordinary device architectures through the additional implementation of circuitry between the individual pixels, or through software post-processing of the recorded images. However, each signal transfer is an energetically costly process, each round of image post-processing using software carries an energetic footprint. So, if a user already knows, that certain information is not relevant for one application, it seems beneficial from an energetic point of view, to not even transfer such information at any stage, so that the relevant information of the image can be analysed in a quick and energetically cheap manner. It is worth remembering at this point that this philosophy and principle is used by nature in the design of the eye, especially for living organism which cannot afford high energetic cost and complicated post-processing to be conducted in the brain.

In other words, exemplary embodiments of the present invention may relate to the development of a photodetector array unit with intrinsic pre-processing functionality of edge and motion definition through the crosstalk between neighbouring pixels comprising the array unit.

The embodiments may have the possibility of expanding the design to a stacked multilayer architecture in order to obtain multidimensional information for each pixel.

Further, exemplary embodiments of the present invention may have one or more of the following features:
- The detectable wavelength range of our photodetector array unit may include visible light (VIS), UV light (UV), NIR light as well as IR (thermal) wavelengths.
- The insulating layer may be composed of liquids, gels, electrolytic solutions, including but not limited to these materials.
- The radiation-responsive conversion elements (e.g. photoactive semiconducting layer) can be composed of organic and inorganic materials, as well as biomolecules, including but not limited to these materials.
- The electrodes can be composed of transparent as well as non-transparent metallic materials.
- Individual photodetector array unit layers can be combined in a stacked arrangement to allow multidimensional light information for each individual pixel.
- The design of each individual pixel is not limited the MISM, but can be expanded to MISIM. Then, the second insulating layer placed between the patterned electrode and the photoactive semiconducting layer is preferably a solid material (so that no crosstalk between pixels happens on this side of the semiconducting layer).
- Direct readout of edge vs. homogenously illuminated object, before the image is transferred.
- Signal is preferably only generated from objects which move within the implemented device bandwidth if no additional shutter system is used.
- The radiation detector may be a passive element (no additional power source required for operation).
- The radiation detector may be a multilayer array, i.e. no colour filter and reduction of "dead" space.

The various embodiments and aspects of embodiments of the invention disclosed herein are to be understood not only in the order and context specifically described in this specification, but to include any order and any combination thereof. Whenever the context requires, all words used in the singular number shall be deemed to include the plural and vice versa. Whenever the context requires, all options that are listed with the word "and" shall be deemed to include the world "or" and vice versa, and any combination thereof.

In the drawings and specification, there have been disclosed a plurality of embodiments of the present invention. The applicant would like to emphasize that each feature of each embodiment may be combined with or added to any other of the embodiments in order to modify the respective embodiment and create additional embodiments. These additional embodiments form a part of the present disclosure and, therefore, the applicant may file further patent claims regarding these additional embodiments at a later stage of the prosecution.

Further, the applicant would like to emphasize that each feature of each of the following dependent claims may be combined with any of the present independent claims as well as with any other (one or more) of the present dependent claims (regardless of the present claim structure). Therefore, the applicant may direct further patent claims towards other claim combinations at a later stage of the prosecution.

## Claims

1. Radiation detector (10) having a conversion unit (100) comprising a radiation-responsive conversion element (120) and an insulator forming a capacitor (C) in series with the conversion element (120),
**characterized in that**
- the radiation detector (10) comprises two or more conversion units (100),
- wherein each of the conversion units (100) comprises a radiation-responsive conversion element (120) and an insulator forming a capacitor (C) in series with the conversion element (120), and
- wherein the insulators of said two or more conversion elements (120) are formed by a common electrolytic layer (130) that electrically couples the capacitors (C) and therefore the conversion units (100).

2. Radiation detector (10) of claim 1,
**characterized in that**
the electrolytic layer (130) consists of or comprises material that forms or is at least able to form electric double layers.

3. Radiation detector (10) of claim 2,
**characterized in that**
the plane of the electric double layers is parallel to the plane in which the conversion elements (120) are located.

4. Radiation detector (10) of any of the preceding claims,
**characterized in that**
- each of the coupled conversion units (100) comprises a first electrode (111) and a second electrode (112),
- wherein the conversion element (120) of each conversion unit (100) is located between the first electrode (111) of the respective conversion unit (100) and the electrolytic layer (130), and
- wherein the electrolytic layer (130) is located between the conversion elements (120) and the second electrodes (112) .

5. Radiation detector (10) of claim 4,
**characterized in that**
each of the coupled conversion units (100) comprises a second insulator that is located between the first electrode (111) and the respective conversion element (120).

6. Radiation detector (10) of any of the preceding claims,
**characterized in that**
the radiation detector (10) comprises at least four coupled conversion units (100) that form a one- or two-dimensional detector array of coupled conversion units (100).

7. Radiation detector (10) of any of the preceding claims,
**characterized in that**
the radiation detector (10) comprises a pre-processing unit (200) configured to generate at least one pre-processed signal (SP) by combining the detector signals (S1, S2) of at least two of the coupled conversion units (100).

8. Radiation detector (10) of claim 7,
**characterized in that**
the pre-processing unit (100) is electrically arranged between a post-processing unit (300) and the coupled conversion units (100).

9. Radiation detector (10) of claim 8,
**characterized in that**
the pre-processing unit (200) is configured to either transfer the detector signals (S1, S2) of the at least two coupled conversion units (100) and/or the respective pre-processed signal (SP) to the post-processing unit (300) or block the transfer depending on a characteristic of the pre-processed signal (SP).

10. Radiation detector (10) of any of the preceding claims 8-9,
**characterized in that**
- the pre-processing unit (200) comprises at least one differential unit (210) that generates the pre-processed signal (SP) by forming a differential signal based on the detector signals (S1, S2) of at least two of the coupled conversion units (100), and
- the pre-processing unit (200) further comprises at least one transfer unit (220) that transfers the detector signals (S1, S2) of the at least two coupled conversion units (100) and/or the respective differential signal (SP) to the post-processing unit (300) if the amplitude of the differential signal exceeds a given threshold, and otherwise blocks the transfer.

11. Radiation detector (10) of any of the preceding claims 8-10,
**characterized in that**
the post-processing unit (300) is configured to operate in a power saving mode at least with respect to those pairs of coupled conversion elements (120) where the transfer of the detector signals (S1, S2) and/or the transfer of the pre-processed signal (SP) is blocked.

12. Radiation detector (10) of any of the preceding claims,
**characterized in that**
the second electrodes (112) of the coupled conversion units (100) are electrically connected or formed by a common electrode (112a) layer.

13. Radiation detector (10) of any of the preceding claims,
**characterized in that**
- the radiation detector (10) comprises two or more conversion sub-stacks (600) that are stacked in a first direction (Z),
- wherein each of the conversion sub-stacks (600) comprises two or more conversion units (100) that are electrically coupled to one another and arranged in a plane perpendicular to the first direction (Z), and
- in each conversion sub-stack (600), the conversion elements (120) are responsive to radiation that is inside a layer-individually assigned wavelength range, and unresponsive to radiation that is outside the layer-individually assigned wavelength range.

14. Radiation detector (10) of claim 13,
**characterized in that**
the conversion elements (120) are aligned in the first direction (Z) such that the conversion units (100) form conversion pillars (610) along the first direction.

15. Radiation detector (10) of any of the claims 13-14,
**characterized in that**
the conversion sub-stacks (600) or at least a sub-group of sub-stacks are connected by one or more through holes (620) that allow a flow of the shared electrolytic layer (130) between - along the first direction (Z) - successive sub-stacks (600).

## Amended claims

### Amended claims in accordance with Rule 137(2) EPC.

**1.** Radiation detector (10) having a conversion unit (100) comprising a radiation-responsive conversion element (120) and an insulator forming a capacitor (C) in series with the conversion element (120),
wherein
- the radiation detector (10) comprises two or more conversion units (100), and
- wherein each of the conversion units (100) comprises a radiation-responsive conversion element (120) and an insulator forming a capacitor (C) in series with the conversion element (120),
**characterized in that**
- the insulators of said two or more conversion elements (120) are formed by a common electrolytic layer (130) that electrically couples the capacitors (C) and therefore the conversion units (100).

**2.** Radiation detector (10) of claim 1,
**characterized in that**
the electrolytic layer (130) consists of or comprises material that forms or is at least able to form electric double layers.

**3.** Radiation detector (10) of claim 2,
**characterized in that**
the plane of the electric double layers is parallel to the plane in which the conversion elements (120) are located.

**4.** Radiation detector (10) of any of the preceding claims, **characterized in that**
- each of the coupled conversion units (100) comprises a first electrode (111) and a second electrode (112),
- wherein the conversion element (120) of each conversion unit (100) is located between the first electrode (111) of the respective conversion unit (100) and the electrolytic layer (130), and
- wherein the electrolytic layer (130) is located between the conversion elements (120) and the second electrodes (112) .

**5.** Radiation detector (10) of claim 4,
**characterized in that**
each of the coupled conversion units (100) comprises a second insulator that is located between the first electrode (111) and the respective conversion element (120).

**6.** Radiation detector (10) of any of the preceding claims,
**characterized in that**
the radiation detector (10) comprises at least four coupled conversion units (100) that form a one- or two-dimensional detector array of coupled conversion units (100).

**7.** Radiation detector (10) of any of the preceding claims,
**characterized in that**
the radiation detector (10) comprises a pre-processing unit (200) configured to generate at least one pre-processed signal (SP) by combining the detector signals (S1, S2) of at least two of the coupled conversion units (100).

**8.** Radiation detector (10) of claim 7,
**characterized in that**
the pre-processing unit (100) is electrically arranged between a post-processing unit (300) and the coupled conversion units (100).

**9.** Radiation detector (10) of claim 8,
**characterized in that**
the pre-processing unit (200) is configured to either transfer the detector signals (S1, S2) of the at least two coupled conversion units (100) and/or the respective pre-processed signal (SP) to the post-processing unit (300) or block the transfer depending on a characteristic of the pre-processed signal (SP).

**10.** Radiation detector (10) of any of the preceding claims 8-9,
**characterized in that**
- the pre-processing unit (200) comprises at least one differential unit (210) that generates the pre-processed signal (SP) by forming a differential signal based on the detector signals (S1, S2) of at least two of the coupled conversion units (100), and
- the pre-processing unit (200) further comprises at least one transfer unit (220) that transfers the detector signals (S1, S2) of the at least two coupled conversion units (100) and/or the respective differential signal (SP) to the post-processing unit (300) if the amplitude of the differential signal exceeds a given threshold, and otherwise blocks the transfer.

**11.** Radiation detector (10) of any of the preceding claims 8-10,
**characterized in that**
the post-processing unit (300) is configured to operate in a power saving mode at least with respect to those pairs of coupled conversion elements (120) where the transfer of the detector signals (S1, S2) and/or the transfer of the pre-processed signal (SP) is blocked.

**12.** Radiation detector (10) of any of the preceding claims,
**characterized in that**
the second electrodes (112) of the coupled conversion units (100) are electrically connected or formed by a common electrode (112a) layer.

**13.** Radiation detector (10) of any of the preceding claims,
**characterized in that**
- the radiation detector (10) comprises two or more conversion sub-stacks (600) that are stacked in a first direction (Z),
- wherein each of the conversion sub-stacks (600) comprises two or more conversion units (100) that are electrically coupled to one another and arranged in a plane perpendicular to the first direction (Z), and
- in each conversion sub-stack (600), the conversion elements (120) are responsive to radiation that is inside a layer-individually assigned wavelength range, and unresponsive to radiation that is outside the layer-individually assigned wavelength range.

**14.** Radiation detector (10) of claim 13,
**characterized in that**
the conversion elements (120) are aligned in the first direction (Z) such that the conversion units (100) form conversion pillars (610) along the first direction.

**15.** Radiation detector (10) of any of the claims 13-14,
**characterized in that**
the conversion sub-stacks (600) or at least a sub-group of sub-stacks are connected by one or more through holes (620) that allow a flow of the shared electrolytic layer (130) between - along the first direction (Z) - successive sub-stacks (600) .

**1.** Radiation detector (10) having a conversion unit (100) comprising a radiation-responsive conversion element (120) and an insulator forming a capacitor (C) in series with the conversion element (120),
wherein
- the radiation detector (10) comprises two or more conversion units (100), and
- wherein each of the conversion units (100) comprises a radiation-responsive conversion element (120) and an insulator forming a capacitor (C) in series with the conversion element (120),
**characterized in that**
- the insulators of said two or more conversion elements (120) are formed by a common electrolytic layer (130) that electrically couples the capacitors (C) and therefore the conversion units (100), and
- the radiation detector (10) comprises a pre-processing unit (200) configured to generate at least one pre-processed signal (SP) by combining the detector signals (S1, S2) of at least two of the coupled conversion units (100) .

**2.** Radiation detector (10) of claim 1,
**characterized in that**
the electrolytic layer (130) consists of or comprises material that forms or is at least able to form electric double layers.

**3.** Radiation detector (10) of claim 2,
**characterized in that**
the plane of the electric double layers is parallel to the plane in which the conversion elements (120) are located.

**4.** Radiation detector (10) of any of the preceding claims,
**characterized in that**
- each of the coupled conversion units (100) comprises a first electrode (111) and a second electrode (112),
- wherein the conversion element (120) of each conversion unit (100) is located between the first electrode (111) of the respective conversion unit (100) and the electrolytic layer (130), and
- wherein the electrolytic layer (130) is located between the conversion elements (120) and the second electrodes (112) .

**5.** Radiation detector (10) of claim 4,
**characterized in that**
each of the coupled conversion units (100) comprises a second insulator that is located between the first electrode (111) and the respective conversion element (120).

**6.** Radiation detector (10) of any of the preceding claims,
**characterized in that**
the radiation detector (10) comprises at least four coupled conversion units (100) that form a one- or two-dimensional detector array of coupled conversion units (100).

**7.** Radiation detector (10) of any of the preceding claims,
**characterized in that**
the pre-processing unit (100) is electrically arranged between a post-processing unit (300) and the coupled conversion units (100).

**8.** Radiation detector (10) of claim 7,
**characterized in that**
the pre-processing unit (200) is configured to either transfer the detector signals (S1, S2) of the at least two coupled conversion units (100) and/or the respective pre-processed signal (SP) to the post-processing unit (300) or block the transfer depending on a characteristic of the pre-processed signal (SP).

**9.** Radiation detector (10) of any of the preceding claims 7-8,
**characterized in that**
- the pre-processing unit (200) comprises at least one differential unit (210) that generates the pre-processed signal (SP) by forming a differential signal based on the detector signals (S1, S2) of at least two of the coupled conversion units (100), and
- the pre-processing unit (200) further comprises at least one transfer unit (220) that transfers the detector signals (S1, S2) of the at least two coupled conversion units (100) and/or the respective differential signal (SP) to the post-processing unit (300) if the amplitude of the differential signal exceeds a given threshold, and otherwise blocks the transfer.

**10.** Radiation detector (10) of any of the preceding claims 7-9,
**characterized in that**
the post-processing unit (300) is configured to operate in a power saving mode at least with respect to those pairs of coupled conversion elements (120) where the transfer of the detector signals (S1, S2) and/or the transfer of the pre-processed signal (SP) is blocked.

**11.** Radiation detector (10) of any of the preceding claims,
**characterized in that**
the second electrodes (112) of the coupled conversion units (100) are electrically connected or formed by a common electrode (112a) layer.

**12.** Radiation detector (10) of any of the preceding claims,
**characterized in that**
- the radiation detector (10) comprises two or more conversion sub-stacks (600) that are stacked in a first direction (Z),
- wherein each of the conversion sub-stacks (600) comprises two or more conversion units (100) that are electrically coupled to one another and arranged in a plane perpendicular to the first direction (Z), and
- in each conversion sub-stack (600), the conversion elements (120) are responsive to radiation that is inside a layer-individually assigned wavelength range, and unresponsive to radiation that is outside the layer-individually assigned wavelength range.

**13.** Radiation detector (10) of claim 12,
**characterized in that**
the conversion elements (120) are aligned in the first direction (Z) such that the conversion units (100) form conversion pillars (610) along the first direction.

**14.** Radiation detector (10) of any of the claims 12-13,
**characterized in that**
the conversion sub-stacks (600) or at least a sub-group of sub-stacks are connected by one or more through holes (620) that allow a flow of the shared electrolytic layer (130) between - along the first direction (Z) - successive sub-stacks (600) .
